# EUROPEAN PATENT APPLICATION

(11) **EP 2 075 790 A2**
(43) Date of publication of application: **01.07.2009**
(21) Application number: 08400059.5
(22) Date of filing: 23.12.2008
(51) Int. Cl.: G09G 3/36

(54) **TFT-LCD driver circuit and LCD devices**

(30) Priority: 27.12.2007 CN 200710305838
(71) Applicant: BYD Company Limited, Shenzhen 518118 (CN)
(72) Inventor: Feng, Wei, Longgang, 518118 Shenzhen (CN); Yang, Yun, Longgang, 518118 Shenzhen (CN); He, Zhiqiang, Longgang, 518118 Shenzhen (CN); Gong, Duo, Longgang, 518118 Shenzhen (CN)
(74) Representative: Bulling, Alexander

(57) **Abstract**

Thin Film Transistor-Liquid Crystal Display (TFT-LCD) driver circuit having a source drive buffer with an operational amplifier having two differential amplifiers operating alternatively according to timing signals and bias voltage signals is disclosed. The differential amplifiers are further capable of functioning as a voltage follower by buffering and outputting voltage signals from a Digital to Analog Converter for charging display points. The TFT-LCD driver circuit may also be incorporated within an LCD device.

## Description

### FIELD OF THE INVENTION

The present invention relates to Liquid Crystal Displays (LCDs), more specifically, to a Thin Film Transistor-Liquid Crystal Display (TFT-LCD) driver circuit and LCD devices.

### BACKGROUND

Current TFT-LCD technologies have been trending toward higher levels of integration, higher resolution and multi-grayscale capabilities. As such, the TFT-LCD driver circuit device area and power consumption have increased accordingly, leading to higher manufacturing costs. In a traditional TFT-LCD driver circuit, a source drive buffer or latch of the source drive chip occupies a large footprint and consumes a considerable amount of power.

Thus, chip designers are starting to look into ways of going about reducing the footprint and/or power consumption of the source drive buffer or latch on the source drive chip.

Accordingly, there is a need for an improved TFT-LCD driver circuit and corresponding LCD devices.

### SUMMARY

An object according to an embodiment of the present invention is to eliminate the large area occupation and the high power consumption of the source drive buffer in the traditional TFT-LCD driver circuit. Accordingly, a first embodiment discloses a TFT-LCD driver circuit including: a gate driver adapted to control turning on of a Thin Film Transistor (TFT); a grayscale voltage generation circuit capable of providing a grayscale voltage for display points; a timing circuit configured to provide timing signals; a bias circuit configured to provide bias voltage signals; and a source driver operable to charge the display points according to the grayscale voltage. The source driver includes: a source drive latch configured to store data for the display points; a source drive buffer; and a Digital to Analog Converter (DAC) configured to output the grayscale voltage to the source drive buffer according to the stored display data. The source drive buffer includes an Operational Amplifier (OPA), which includes first and second differential amplifiers, The differential amplifiers operate alternatively according to the timing signals and bias voltage signals, and buffer and output voltage signals outputted from the DAC by means of a voltage follower mechanism for charging the display points.

The source drive buffer further includes a CMOS transmission gate in parallel with the OPA, and the CMOS transmission gate is capable of adjusting the voltage output of the OPA using output voltage signals outputted from the DAC under the control of the timing signals while the OPA is off.

The first differential amplifier includes: a first differential circuit having two N-channel Metal Oxide Semiconductor (NMOS), wherein the gate of the first NMOS is coupled to the output of the DAC and the gate of the second NMOS is coupled to the output of the OPA; a first current mirror source being a loader of the first differential circuit; an end of current source; an output stage which includes a NMOS and a PMOS, the gate of the NMOS and the end of current source being controlled by the bias voltage signals, the gate of the PMOS being coupled to the output of the first current mirror source; and a power down PMOS operable to turning on and off the OPA by timing signals.

The second differential amplifier includes: a second differential circuit having two P-channel Metal Oxide Semiconductor (PMOS), wherein the gate of the first PMOS is coupled to the output of the DAC while the gate of the second PMOS is coupled to the output of the OPA; a second current mirror source being a loader of the second differential circuit; an end of current source; an output stage which includes a PMOS and a NMOS, the gate of the PMOS and the end of current source being controlled by the bias voltage signals, the gate of the NMOS being coupled to the output of the second current mirror source; and a power down NMOS which is applied for turning on and off OPA by timing signals.

In an embodiment, during sub-threshold zone, the threshold voltage of the OPA is higher than the bias voltage signals generated by the bias circuit.

In an embodiment, an LCD device can be manufactured having a TFT panel and using the TFT-LCD driver circuit as described above.

Other variations, embodiments and features of the present invention will become evident from the following detailed description, drawings and claims.

### BRIEF DESCRIPTION OF THE DRAWINGS

Fig. 1 illustrates a typical circuit diagram of a TFT panel;
Fig. 2 illustrates a schematic diagram of the TFT-LCD driver circuit according to a first embodiment of the present invention;
Fig. 3 illustrates the relationship between input and output signals of an OPA of a source drive buffer of Fig. 2;
Fig. 4 illustrates a circuit diagram of the OPA according to an embodiment of the present invention;
Fig. 5 illustrates a circuit diagram of a CMOS transmission gate of the source drive buffer according to an embodiment of the present invention;
Fig. 6 illustrates a diagram of a control circuit for bias voltages PBIASL and NBIASL of the TFT-LCD driver circuit according to an embodiment of the present invention;
Fig. 7 illustrates waveforms of the bias voltages PBIASL and NBIASL of the TFT-LCD driver circuit according to an embodiment of the present invention;
Fig. 8 illustrates waveforms of timing signals SWITCH and SWITCH_N and some other timing signals of the source driver according to an embodiment of the present invention; and
Fig. 9 illustrates waveforms of the voltage generated by the DAC that is buffered and outputted by the source drive buffer according to an embodiment of the present invention under the control of the various timing signals.

### DETAILED DESCRIPTION OF THE EMBODIMENTS

It will be appreciated by those of ordinary skill in the art that the invention can be embodied in other specific forms without departing from the essential characteristics thereof. The presently disclosed embodiments are therefore considered in all respects to be illustrative but not restrictive.

The source drive buffer of the TFT-LCD driver circuit of the presently disclosed embodiments can be formed with two basic differential amplifiers and a CMOS transmission gate. The two differential amplifiers can be turned on alternatively according to timing of control signals, adjust an output voltage through the COMS transmission gate, and charge pixels in a row to the required voltage level until scanning of the pixels in the row is completed.

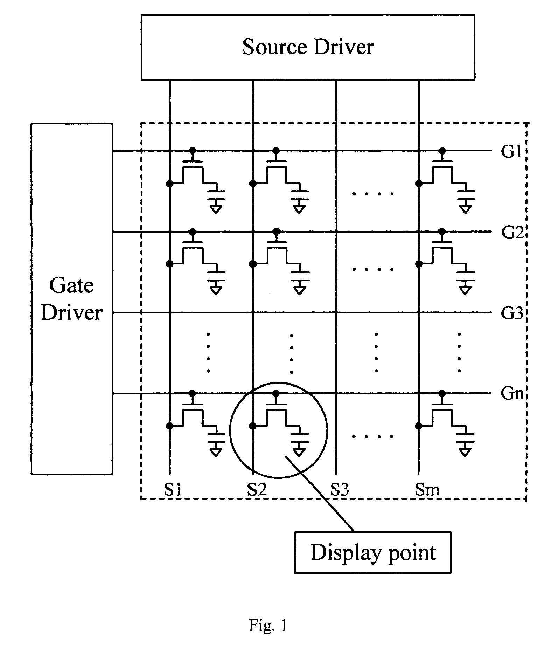

Fig. 1 illustrates a typical circuit diagram of a TFT panel. The TFT panel provides a plurality of display points forming an n×m matrix with n rows (G1, G2, G3, ..., Gn) and m columns (S1, S2, S3, ...,Sm), wherein each display point represents a Twisted Nematic Liquid Crystal Display (TN-LCD) point and includes a TFT, a parallel plate capacitor (not shown) formed with upper and lower conductive glasses and a storage capacitor, the parallel plate capacitor and storage capacitor having parallel coupling. If a color filter has three basic colors, a basic pixel display unit needs to be provided with three such display points corresponding to red, green and blue, i.e. the three basic primary colors. At a specific time, the gate driver outputs a drive pulse to turn on all TFT's in a row. At the same time, the source driver charges the display points in the row to the necessary voltage. When the charging of the row is completed, the gate driver turns off the TFT's in the row, turns on TFT's in the next row, and charges the display points in the next row.

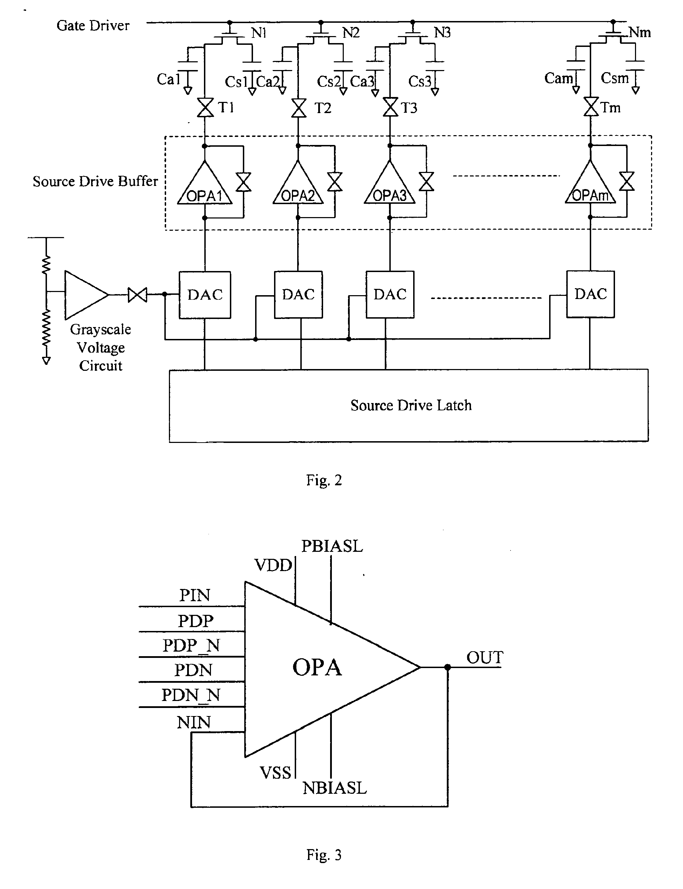

Fig. 2 illustrates a circuit diagram of a TFT-LCD driver circuit according to the first embodiment of the present invention. For the sake of description, only TFT-components of the LCD driver circuit involved in the invention are shown in Figure 2. The TFT-LCD driver circuit includes gate and source drivers, a grayscale voltage generator with a timing generator (not shown), and a bias voltage generator (not shown).

As shown in Fig. 2, TFTs N1-Nm are provided in the row. A gate of each of the TFTs is turned on or off under the control of the dirve pulse outputted from the gate driver, m sources of the TFTs are respectively coupled to outputs of source drivers, and m drains of the TFTs are respectively coupled to storage capacitors Cs1-Csm. When the row is canned, all the TFTs of the row are turned on by the drive pulse outputted from the gate driver. At the same time, latch data stored within the source drive latch is decoded and converted by Digital to Analog Converters (DACs), to select a grayscale voltage generator to generate the grayscale voltage to be supplied to each display point. The grayscale voltage is transmitted through the source drive buffer and a corresponding one of the transmission gates T1-Tm to charge a display electrode of the respective display point, thereby driving the LCD panel. As shown in Fig. 2, m source drive buffers (within the dashed outline) corresponds to m display points in the row under scan, and each source drive buffer includes an operational amplifier (OPA).

Fig. 3 illustrates the relationship between input and output signals of the OPA of the source drive buffer as shown in Fig. 2. Specifically, the OPA receives the voltage signal PIN from the corresponding DAC, latches the voltage signal PIN and charges the corresponding display electrode through the corresponding one of the transmission gates T1-Tm (as shown in Fig. 2) under the control of timing signals PDP, PDP_N, PDN, PDN_N and bias voltage signals PBIASL and NBIASL. The output OUT of the OPA is short connected to a feedback NIN, causing the output voltage to be fed back to the feedback NIN of the OPA, and the entire OPA is equivalent to a voltage follower. The various timing signals are generated by the timing generators of the TFT-LCD driver circuit.

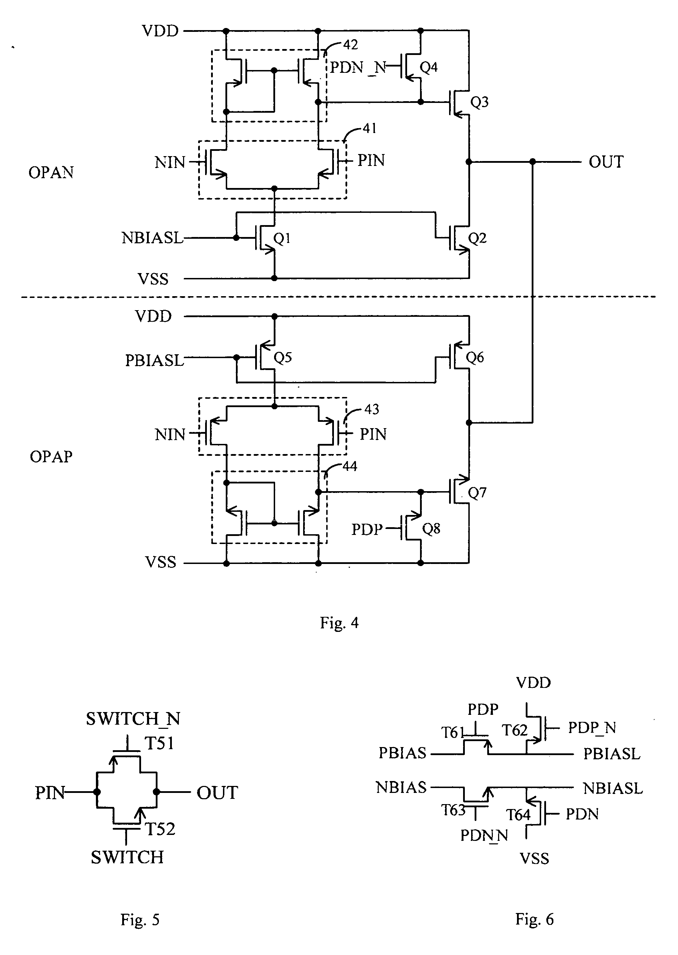

Fig. 4 is a circuit diagram of the OPA according to an embodiment of the present invention. The OPA includes a first differential amplifier (OPAN) and a second differential amplifier (OPAP), which operate alternatively under the control of timing signals. The input stage of the OPAN includes a first differential circuit 41 having two N-channel Metal Oxide Semiconductors (NMOSs), and the gates of the NMOSs are coupled to the voltage output PIN of the DAC and the output OUT of the source drive buffer. The sources of the two NMOSs can be coupled to each other to form a coupled source pair, and connected with the ground potential VSS of the driver circuit via a first switch Q1. Depending on the bias at the first switch Q1, the drains of the first differential circuit 41 are coupled to the power terminal VDD of the drive circuit via a first current mirror source 42. With the first current mirror source 42 as the load, the output impedance is improved to obtain a higher gain. The output stage of the OPAN is of a simple co-source structure to improve the range of the output waveforms, and is formed with a second switch Q2 and a third switch Q3 coupled in series, and the coupling node between the switches Q2 and Q3 is the output OUT of the OPA. The gates of the second switch Q2 and the first switch Q1 are coupled in series, and turned on under the control of the bias voltage signal NBIASL. The gate of the third switch Q3 is coupled to the source of the first current mirror source 42, and also to the power terminal VDD of the drive circuit via a fourth switch Q4. The gate of the fourth switch Q4 can be turned on under the control of the timing signal PDN_N, to control and ensure that the OPAN is working properly.

Similarly, the input stage of the OPAP includes a second differential circuit 43 formed with two P-channel Metal Oxide Semiconductors (PMOSs), and the gates of the two PMOSs are coupled to the voltage output PIN of the DAC and the output OUT of the source drive buffer. The sources of the two PMOSs are connected with the power terminal VDD of the drive circuit via a fifth switch Q5. Depending on the bias at the fifth switch Q5, the drains of the second differential circuit 43 are coupled to the ground potential VSS of the driver circuit via a second current mirror source 44. With the second current mirror source 44 as the load, the output impedance is improved to obtain a higher gain. The output stage of the OPAP is of a simple co-source structure, and includes sixth and seventh switches Q6, Q7 coupled in series, and the coupling node between the switches Q6 and Q7 is the output OUT of the OPA. The gates of the sixth switch Q6 and the fifth switch Q5 are coupled in series, and are turned on under the control of the bias voltage control signal PBIASL. The gate of the seventh switch Q7 is coupled to the source of the second current mirror source 44, and also to the ground potential VSS of the driver circuit via an eighth switch Q8. The gate of the eighth switch Q8 can be turned on under the control of the timing signal PDP, to control the operation status of the OPAP.

The two differential amplifiers OPAN and OPAP of the OPA as shown in Fig. 4 operate alternatively under the control of the timing signals, with the OPAN being effective when the voltage rises and the OPAP being effective when the voltage decreases. During the scanning of a row, there is only one contribution from the OPA, which in turn causes differentiation between the output waveform and actual input waveform of the buffer. Accordingly, in one preferred embodiment of the present invention, the OPA within the buffer can be coupled in parallel to a CMOS transmission gate as shown in Fig. 5, which adjusts the output waveform. The source of the PMOS T51 and the drain of the NMOS T52 can be coupled to form an input of the CMOS transmission gate, while the drain of the PMOS T51 and the source of the NMOS T52 can be coupled to form an output of the CMOS transmission gate. Because the sources and drains of the NMOS and PMOS can be exchanged, other coupling structures may be utilized. For example, the drains of the NMOS and PMOS are coupled and the sources of the NMOS and PMOS are coupled. The PMOS T51 and the NMOS T52 can be turned on under the control of a pair of complementary timing signals SWITCH and SWITCH_N. The input of the CMOS transmission gate can be coupled to the input PIN of the OPA while the output of the CMOS transmission gate can be connected to the output OUT of the OPA.

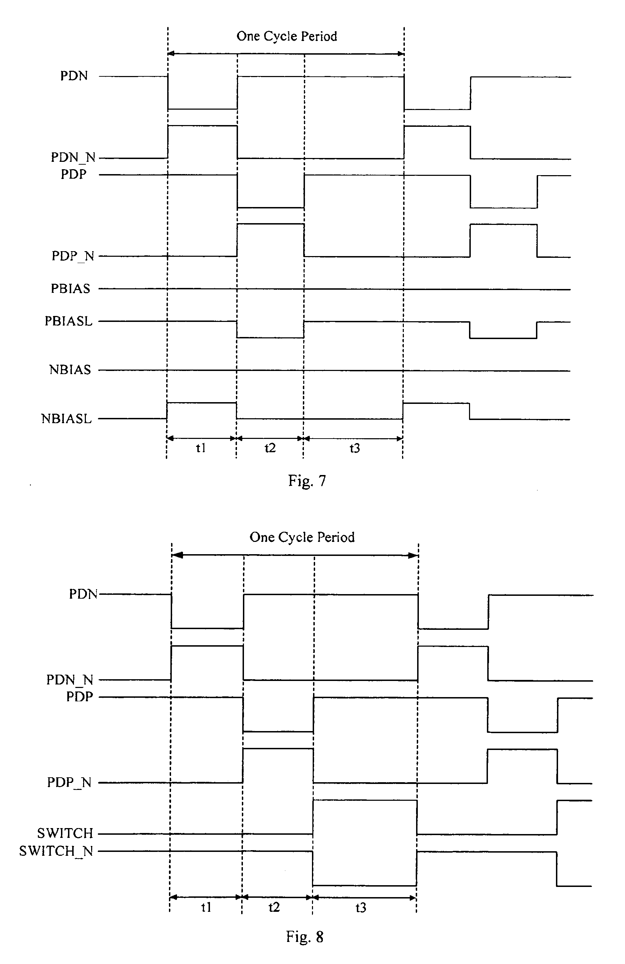

Figs. 6 and 7 respectively illustrate a control circuit diagram and waveforms of the bias voltages PBIASL and NBIASL in the TFT-LCD driver circuit according to an embodiment of the present invention. The generator which generates the bias voltage signals PBIASL and NBIASL serves as a global circuit module which provides the bias voltages for all source drive buffers in the TFT-LCD driver circuit, while the other circuit modules in the TFT-LCD driver circuit are provided with bias voltages by the bias voltage signals PBIAS and NBIAS.

As shown in Figs. 6 and 7, during periods t1 and t3 within a cycle of gate scanning a row, PDP is at a high voltage level while PDP_N is at a low voltage level. In this case, a switch T62 is on, a switch T61 is off, and the bias voltage signal PBIASL is pulled up to a system high voltage level VDD. During period t2, the PDP is at a low voltage level while the PDP_N is at a high voltage level. In this case, the switch T61 is on, the switch T62 is off, and the bias voltage signal PBIAS is directly outputted as the bias voltage signal PBIASL. Similarly, during the period t1, the PDN is at a low voltage level while the PDN_N is at a high voltage level. In this case, a switch T63 is on, a switch T64 is off, and the bias voltage signal NBIAS is directly outputted as the bias voltage signal NBIASL. During the periods t2 and t3, the PDN is at a high voltage level while the PDN_N is at a low voltage level. In this case, the switch T64 is on, the switch T63 is off, and the bias voltage signal NBIASL is pulled down to a system low voltage level VSS. The waveforms of the bias voltage signals PBIASL and NBIASL are shown in Fig. 7, while the waveforms of timing signals SWITCH and SWITCH_N and other timing signals are shown in Fig. 8.

With reference to Figs. 2-8, the working principles of the source drive buffer according to an embodiment of the present invention during the time for scanning a row, i.e. periods tl+t2+t3, are described as follows. The data as stored in the source drive latch are decoded and converted by the DAC, to select the grayscale voltage generator to generate the appropriate grayscale voltage. During period t1, the first switch Q1 and the second switch Q2 are turned on by the bias voltage signal NBIASL, and both the first differential circuit 41 and the first current mirror source 42 start to operate. Because the PDN_N is at a high voltage level, the fourth switch Q4 is off, the OPAN is able to function normally, and the voltage generated by the grayscale voltage generator is buffered and outputted. Further, because the bias voltage signal PBIASL is at a high voltage level, the fifth switch Q5 is off, and because the PDP is at a high voltage level, the eighth switch Q8 is on, thereby pulling down or lowering the gate voltage of the seventh switch Q7 to the low voltage level VSS, turning off the OPAP. That is, the OPAN is in operation during the period t1. During the period t2, the OPAP is operative, the control principle of which is opposite to that during the period t1, and thus will not be elaborated further herein. Because the entire OPA is equivalent to a voltage follower, during the periods t1 and t2, the voltage following approach ensures that the level of the output OUT is equal to the level of the input PIN. It should be appreciated by one skilled in the art that the previously described scenario may be reversed by means of timing control such that the OPAP is in operation during period t1 while the OPAN is in operation during period t2. The operational functions of the amplifiers and corresponding grayscale voltages are similar to those described above and thus will not be elaborated further herein.

During period t3, neither of the bias voltage signals NBIASL and PBIASL can turn on the first and fifth switches Q1 and Q5. Both the first and second differential amplifiers OPAN and OPAP are off, in this case, the CMOS transmission gate is turned on under the control of the timing signals SWITCH and SWITCH_N, thereby short connecting the input and output of the source drive buffer, and the output of the source drive buffer is adjusted by the voltage from the DAC and reaches or is close to an ideal value.

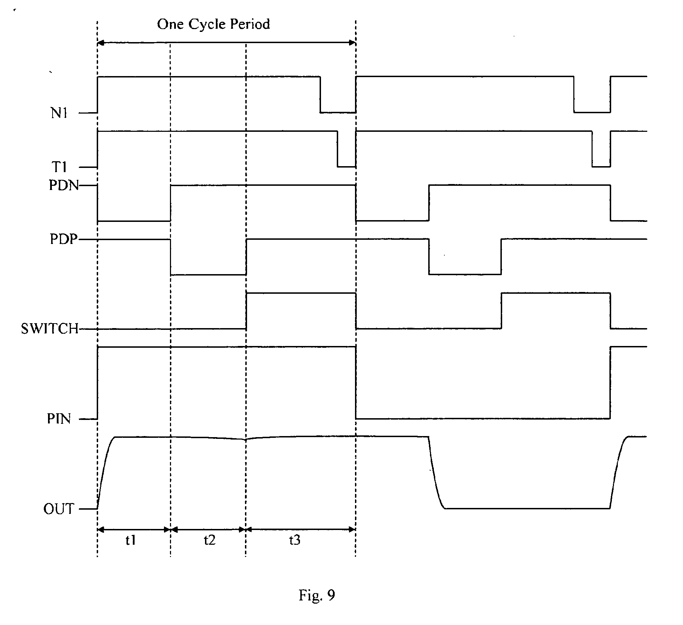

Fig. 9 illustrates waveforms of the voltage generated by the DAC that is buffered and outputted by the source drive buffer according to an embodiment of the present invention under the control of the various timing signals. Specifically, N1 represents the drive pulse waveform outputted from the gate driver, T1 represents the waveform of the transmission gate as shown in Fig. 2, PIN represents the output waveform of the DAC, and OUT represents the output waveform of the source drive buffer.

In the embodiments described above, the first differential amplifier OPAN is effective when the voltage rises, i.e. dominant when the input voltage changes from a low level to a high level, while the second differential amplifier OPAP is effective when the voltage decreases, i.e. dominant when the input voltage changes from a high level to a low level. Therefore, only one differential amplifier is contributing to the system during the time for scanning one row, thereby causing differentiation between the output waveform and the actual input waveform of the buffer. However, after adjustments by the grayscale voltage, the differentiation will not influence the display on the LCD, because the voltage in the storage capacitor Cs of the LCD panel just before the TFT is turned off is stored, that is, the output of the cache has reached or been close to an ideal value when N1 is changed from the higher voltage to the lower voltage.

The presently disclosed embodiments, in order to reduce static power consumption of power amplifiers, the power amplifiers operate in the sub-threshold zone, and the voltage values of the bias voltage signals PBIAS and NBIAS are slightly lower than the threshold voltage.

Additionally, to expand the range of the common-mode input, mixed use of an NMOS differential pair (first differential amplifier) and a PMOS differential pair (second differential amplifier) may be incorporated as a two-tier operational amplifier. The two operational amplifiers operate in a time division mode through timing control, thereby effectively improving the range of the input voltage. Further, because of the reduced complexity of the source drive buffer, circuitry dimensions can be reduced and less area or die size would be required. Furthermore, power consumption can also be reduced because the two differential operational amplifiers operate in a time division mode.

Although the invention has been described in detail with reference to several embodiments, additional variations and modifications exist within the scope of the invention as described and defined in the following claims.

## Claims

1. A Thin Film Transistor-Liquid Crystal Display, TFT-LCD, driver circuit comprising:
a gate driver adapted to control turning on of a TFT; a grayscale voltage generation circuit adapted to provide a grayscale voltage for display points;
a timing circuit configured to provide a plurality of timing signals;
a bias circuit configured to provide a plurality of bias voltage signals; and
a source driver operable to charge the display points according to the grayscale voltage, wherein the source driver comprises:
a source drive latch configured to store data for display points;
a source drive buffer; and
a Digital to Analog Converter, DAC, configured to output the grayscale voltage to the source drive buffer according to the stored data;
wherein, the source drive buffer comprises an operational amplifier, which comprises a first differential amplifier and a second differential amplifier, the first and second differential amplifiers operate alternatively according to the timing signals and the bias voltage signals, to buffer and output voltage signals outputted from the DAC in a voltage follower mechanism for charging the display points.

2. The circuit of claim 1, wherein the source drive buffer further comprises a CMOS transmission gate in parallel with the operational amplifier, and when the operational amplifier is off, the CMOS transmission gate adjusts the voltage output of the operational amplifier using the voltage signals outputted from the DAC under the control of the timing signals.

3. The circuit of claim 1, wherein the first differential amplifier comprises:
a first differential circuit having two N-channel Metal Oxide Semiconductor, NMOS, wherein a gate of the first NMOS is coupled to the output of the DAC and a gate of the second NMOS is coupled to the output of the operational amplifier;
a first current mirror source being a loader of the first differential circuit;
an end of current source;
an output stage which comprises a NMOS and a PMOS, the gate of the NMOS and the end of current source being controlled by the bias voltage signals, the gate of the PMOS being coupled to the output of the first current mirror source; and
a power down PMOS operable to turning on and off the operational amplifier by timing signals.

4. The circuit of claim 1, wherein the second differential amplifier comprises:
a second differential circuit having two P-channel Metal Oxide Semiconductor, PMOS, wherein a gate of the first PMOS is coupled to the output of the DAC while a gate of the second PMOS is coupled to the output of the operational amplifier;
a second current mirror source being a loader of the second differential circuit;
an end of current source;
an output stage which comprises a PMOS and a NMOS, the gate of the PMOS and the end of current source being controlled by the bias voltage signals, the gate of the NMOS being coupled to the output of the second current mirror source; and
a power down NMOS which is applied for turning on and off operational amplifier by timing signals.

5. The circuit of any one of claims 1 to 4, wherein the operational amplifier operates in a sub-threshold zone, and the threshold voltage of the operational amplifier is higher than the bias voltage signals generated by the bias circuit.

6. A Liquid Crystal Display, LCD, device comprising:
a Thin Film Transistor, TFT, panel; and
a TFT-LCD driver circuit comprising:
a gate driver adapted to control turning on of a TFT; a grayscale voltage generation circuit adapted to provide a grayscale voltage for display points;
a timing circuit configured to provide a plurality of timing signals;
a bias circuit configured to provide a plurality of bias voltage signals; and
a source driver operable to charge the display points according to the grayscale voltage, wherein the source driver comprises:
a source drive latch configured to store data for display points;
a source drive buffer; and
a Digital to Analog Converter, DAC, configured to output the grayscale voltage to the source drive buffer according to the stored data;
wherein, the source drive buffer comprises an operational amplifier, which comprises a first differential amplifier and a second differential amplifier, the first and second differential amplifiers operate alternatively according to the timing signals and the bias voltage signals, to buffer and output voltage signals outputted from the DAC in a voltage follower mechanism for charging the display points.

7. The device of claim 6, wherein the source drive buffer further comprises a CMOS transmission gate in parallel with the operational amplifier, and when the operational amplifier is off, the CMOS transmission gate adjusts the voltage output of the operational amplifier using the voltage signals outputted from the DAC under the control of the timing signals.

8. The device of claim 6, wherein the first differential amplifier comprises:
a first differential circuit having two N-channel Metal Oxide Semiconductor, NMOS, wherein a gate of the first NMOS is coupled to the output of the DAC and a gate of the second NMOS is coupled to the output of the operational amplifier;
a first current mirror source being a loader of the first differential circuit;
an end of current source;
an output stage which comprises a NMOS and a PMOS, the gate of the NMOS and the end of current source being controlled by the bias voltage signals, the gate of the PMOS being coupled to the output of the first current mirror source; and
a power down PMOS operable to turning on and off the operational amplifier by timing signals.

9. The device of claim 6, wherein the second differential amplifier comprises:
a second differential circuit having two P-channel Metal Oxide Semiconductor, PMOS, wherein a gate of the first PMOS is coupled to the output of the DAC while a gate of the second PMOS is coupled to the output of the operational amplifier;
a second current mirror source being a loader of the second differential circuit;
an end of current source;
an output stage which comprises a PMOS and a NMOS, the gate of the PMOS and the end of current source being controlled by the bias voltage signals, the gate of the NMOS being coupled to the output of the second current mirror source; and
a power down NMOS which is applied for turning on and off operational amplifier by timing signals.

10. The device of any one of claims 6 to 9, wherein the operational amplifier operates in a sub-threshold zone, and the threshold voltage of the operational amplifier is higher than the bias voltage signals generated by the bias circuit.

11. A Thin Film Transistor-Liquid Crystal Display, TFT-LCD, driver circuit comprising:
a gate driver adapted to control turning on of a TFT; a grayscale voltage generation circuit adapted to provide a grayscale voltage for display points;
a timing circuit configured to provide a plurality of timing signals;
a bias circuit configured to provide a plurality of bias voltage signals; and
a source driver operable to charge the display points according to the grayscale voltage, wherein the source driver comprises:
a source drive latch configured to store data for display points;
a source drive buffer; and
a digital to analog converter, DAC, configured to output the grayscale voltage to the source drive buffer according to the stored data;
wherein, the source drive buffer comprises an operational amplifier, the operational amplifier having:
a first differential amplifier comprising:
a first differential circuit having two N-channel Metal Oxide Semiconductor, NMOS, wherein a gate of the first NMOS is coupled to the output of the DAC and a gate of the second NMOS is coupled to the output of the operational amplifier;
a first current mirror source being a loader of the first differential circuit;
a first end of current source;
an output stage which comprises a third NMOS and a third PMOS, the gate of the third NMOS and the first end of current source controlled by the bias voltage signals, the gate of the third PMOS coupled to the output of the first current mirror source;
a power down PMOS operable to turning on and off the operational amplifier by timing signals;
a second differential amplifier comprising:
a second differential circuit having two P-channel Metal Oxide Semiconductor, PMOS, wherein a gate of the first PMOS is coupled to the output of the DAC while a gate of the second PMOS is coupled to the output of the operational amplifier;
a second current mirror source being a loader of the second differential circuit;
a second end of current source;
an output stage which comprises a fourth PMOS and a fourth NMOS, the gate of the fourth PMOS and the end of current source controlled by the bias voltage signals, the gate of the fourth NMOS coupled to the output of the second current mirror source;
a power down NMOS which is applied for turning on and off operational amplifier by timing signals; and
wherein the two differential amplifiers operate alternatively according to the timing signals and the bias voltage signals, to buffer and output voltage signals outputted from the DAC in a voltage follower mechanism for charging the display points.

12. The circuit of claim 11, wherein the source drive buffer further comprises a CMOS transmission gate in parallel with the operational amplifier, and when the operational amplifier is off, the CMOS transmission gate adjusts the voltage output of the operational amplifier using the voltage signals outputted from the DAC under the control of the timing signals.

13. The circuit of claim 11, wherein the operational amplifier operates in a sub-threshold zone, and the threshold voltage of the operational amplifier is higher than the bias voltage signals generated by the bias circuit.
